# EUROPEAN PATENT APPLICATION

(11) **EP 3 355 374 A1**
(43) Date of publication of application: **01.08.2018**
(21) Application number: 16848897.1
(22) Date of filing: 21.09.2016
(51) Int. Cl.: H01L 51/42, H01L 51/00, H01L 31/0256

(54) **FLEXIBLE DEVICE AND MANUFACTURING METHOD THEREFOR**

(30) Priority: 22.09.2015 KR 20150133641
(71) Applicant: Kolon Industries, Inc., Gwacheon-si, Gyeonggi-do 13837 (KR)
(72) Inventor: KAL, Jin Ha, Yongin-si Gyeonggi-do 16910 (KR); PARK, Hong Kwan, Yongin-si Gyeonggi-do 16910 (KR); HAHN, Jung Seok, Yongin-si Gyeonggi-do 16910 (KR)
(74) Representative: Ter Meer Steinmeister & Partner
(86) International application number: PCT/KR2016/010500
(87) International publication number: WO 2017/052171

(57) **Abstract**

**Abstract:** The present invention relates to a method for manufacturing a flexible device and the flexible device manufactured thereby, the method comprising: a step of forming a first electrode layer on a central area, excluding the edge areas of both ends in the widthwise direction, of a substrate; a step of forming an active layer on the first electrode layer by all-over coating the same, while transferring the substrate having the first electrode layer formed thereon; a step of forming a second electrode layer on the all-over coated active layer; and a dividing step of forming unit cells by removing partial areas of the all-over coated active layer, in order to electrically insulate and divide the all-over coated active layer into a plurality of unit cells. The method for manufacturing a flexible device can reduce a variation in the thickness of unit cells through all-over coating, easily establish a standard process, and form cells of various sizes and manufacture modules with various electrical specifications through an easier physical cutting or post-processing process than pattern printing.

## Description

### [Technical Field]

The present invention relates to a flexible device and a method for manufacturing the same, and more particularly, to a flexible device and a method for manufacturing the same, in which patterns are divided through a physical cutting or post-treatment process after all-over coating rather than pattern printing, so that application of various thin film process conditions according to pattern shapes is not required, thickness variation between unit cells may be reduced through all-over coating and a single all-over coating condition may be employed, thereby facilitating standard process establishment and raising process reliability and yield, forming cells having various sizes and manufacturing modules having various electrical specifications through the easier physical cutting or post-treatment process than pattern printing.

### [Background Art]

In general, as devices having various types are developed and applied to various fields, demand for flexible devices is increasing and, as wearable devices, such as smart glasses, etc., become known and exposed to the public, importance thereof is further increased. In relation to wearable devices, innovative products in various fields, such as not only technical leading companies in Information & Communication Technology (ICT) but also sports equipment manufacturers, are launched. As next-generation smart devices after the smartphone age, wearable devices are selected by various business operators in various fields as a new business line.

A wearable device means an electronic device which a user can wear. However, the wearable device is not an electronic device which a user simply wears like accessories but is an electronic device which may communicate with a user at the closest position of their body part. Wearable devices are advantageous in that they may continuously collect detailed information regarding surrounding environments and changes in individual bodies in real time. However, the wearable devices are worn or mounted on curved human bodies or curved regions, such as columns of buildings, and thus devices having a standardized shape, such as devices formed of glass, are difficult to apply to wearable devices and a process of forming a flexible device is executed at a high temperature and thus materials having flexibility and high heat resistance should be used as a material of the flexible device. In more detail, various materials including a film having high heat resistance, such as polyimide, a metal foil having an easily deformable shape and fiberglass having high heat resistance, the surface of which is treated with a resin, have been considered and applied and, recently, development of a flexible device using thin glass is ongoing.

Such an effort is also applied to a new renewable energy field. Recently, solar cells have come into the spotlight as alternative new renewable energy to reduce CO₂ emissions and protect global environment. Particularly, Japan, Germany, Europe and the United States commercialized solar cells as new clean energy through a lot of research and development. Solar cells, which are commercialized now, are mainly Si-based, CdTe-based and CIGS-based solar cells based on inorganic semiconductor technology. However, such inorganic solar cells are advantageous in that they have high energy conversion efficiency of 15% to 20%, but are disadvantageous in that they are manufactured through a high-energy and high-cost manufacturing method using a high-temperature and vacuum semiconductor process. Further, the inorganic solar cells have possibilities of a resource depletion problem of materials used in the semiconductor process, a scarce inorganic material securement problem and an environment contamination problem of hazardous materials in the process.

On the other hand, in case of organic solar cells, a module may be manufactured through a printing process at a temperature of 150°C or lower on a plastic film in the atmosphere and, thus, a lightweight and bendable structure having a large size may be implemented. Particularly, energy consumption in manufacture of organic solar cells may be reduced using continuous roll-to-roll process equipment corresponding to the core of printed electronics technology, and a manufacturing time of the organic solar cells is short and thus manufacturing costs of the organic solar cells may be greatly reduced due to mass production. Further, the organic solar cells may be mass-produced as customized organic solar cells and thus freely applied to portable electronic devices, clothes, leisure equipment, etc., and convert individuals into prosumers (Production + Consumers) which are main agents of both energy consumption and production and thus increase supply of new renewable energy.

As such, as research and development of various flexible devices and various application plans thereof are carried out, the flexible devices need to have various sizes according to application shapes and positions thereof and areas of application sites thereof. Here, if separate flexible devices are respectively manufactured according to application shapes and positions thereof and areas of application sites thereof, production efficiency is declined. Further, in order to maximize efficiency of a flexible device, the flexible device should absorb light through a large area thereof and, thus, requires a large size. However, in this case, flexible devices need to be customized to have various shapes according to various purposes of use and this may cause problems, such as decrease in productivity, high costs, difficulty in repair and maintenance, etc.

In this aspect, the organic solar cells are advantageous in that they may be mass-produced through the roll-to-roll process and thus electronic devices having high flexibility and lightweight may be manufactured at low costs.

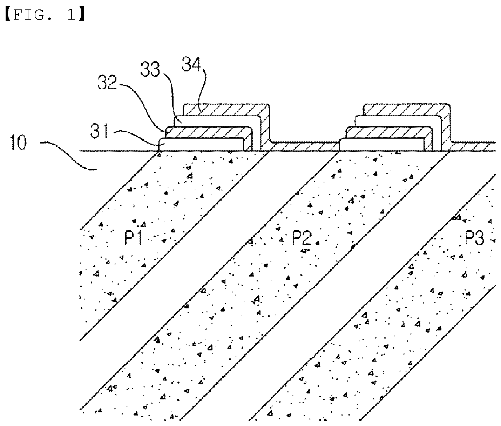

FIG. 1 is a view exemplarily illustrating a stacked cross-section of a conventional organic solar cell.

With reference to FIG. 1, the organic solar cell may include a substrate 10, and first electrodes 31, a photoactive layer 32, a transport layer 33 and second electrodes 34 which are sequentially stacked on the substrate 10, and the transport layer 34 may be an electron transport layer or a hole transport layer formed on one of both surfaces of the photoactive layer 32. Stack areas, in which the first electrodes 31, the photoactive layer 32, the transport layer 33 and the second electrodes 34 are stacked, are distinguished from the edge areas of the substrate 10 and thus form unit cells formed as stripe patterns P1, P2 and P3.

The unit cells formed as the stripe patterns P1, P2 and P3 are electrically connected to the neighboring unit cells by the second electrodes 34 and, thus, the unit cells may form an array. The unit cells formed as the stripe patterns P1, P2 and P3 are connected to each other by the second electrodes 34, the unit cells formed as the stripe patterns P1, P2 and P3 should have the same electrical characteristics and thus maintain regular width and thickness, and the unit cells require good alignment of the respective stripe patterns P1, P2 and P3.

However, among methods of forming the stripe patterns P1, P2 and P3, in case of a method using a slot-die in which a stack is directly discharged onto the substrate 10 as a pattern shape, a fluid does not uniformly flow in the slot-die and thus variation in alignment of the patterns occurs whenever a process is carried out and, thereby, variation in uniformity of the unit cells formed along the stripe patterns P1, P2 and P3 may occur. Further, if the unit cells are formed using the slot-die, electrical characteristics, for example, output voltage and output current, of the organic solar cell are fixed according to the number and area of the stripe patterns P1, P2 and P3 of the organic solar cell desired to be formed. This means that electrical characteristics of organic solar cells manufactured according to organic solar cell production lines are fixed.

### [Disclosure]

### [Technical Problem]

Therefore, the present invention has been made in view of the above problems, and it is an object of the present invention to provide a method for manufacturing a flexible device, in which patterns are divided through a physical cutting or post-treatment process after all-over coating rather than pattern printing, so that application of various thin film process conditions according to pattern shapes is not required, thickness variation between unit cells may be reduced through all-over coating and a single all-over coating condition may be employed, thereby facilitating standard process establishment and raising process reliability and yield, forming cells having various sizes and manufacturing modules having various electrical specifications through the easier physical cutting or post-treatment process than pattern printing.

It is another object of the present invention to provide a flexible device manufactured by the above-described method.

### [Technical Solution]

The object of the present invention can be achieved by providing a flexible device including a substrate and a plurality of unit cells located on the substrate, wherein the substrate includes a central area provided with the unit cells located thereon, edge areas formed at both ends of the substrate in a widthwise direction and provided with no unit cells, and perforated parts formed between the unit cells in the central area of the substrate to electrically insulate and divide the unit cells.

The unit cells may be arranged at regular intervals in a lengthwise direction of the substrate.

The perforated parts may be extended to a part of each of the edge areas of the substrate.

The perforated parts may be formed through the unit cells and the substrate.

The perforated parts may have an elongated shape in the widthwise direction of the substrate.

The flexible device may further include a first barrier film formed under the substrate, and a second barrier film formed on the unit cells.

The flexible device may further include a first adhesive layer provided between the first barrier film and the substrate, and a second adhesive layer provided between the second barrier film and the unit cells.

The first barrier film and the second barrier film may be in contact with each other at the perforated parts.

As the first barrier film and the second barrier film are in contact with each other at the perforated parts, joints may be formed on the surfaces of the first barrier film and the second barrier film.

Each of the unit cells may include a first electrode layer and a second electrode layer, arranged on the substrate so as to face each other, and an active layer located between the first electrode layer and the second electrode layer.

The first electrode layer and the second electrode layer may include electrode terminals protruding in the widthwise direction of the substrate.

The electrode terminals of the first electrode layer and the electrode terminals of the second electrode layer may be alternately arranged in a lengthwise direction of the substrate.

The flexible device may further include electrode connection lines configured to connect the electrode terminals, in the edge areas of the substrate.

The perforated part may be formed within a region formed by a space between the neighboring unit cells, and the electrode connection line so as not to cut the electrode connection line.

The flexible device may be an organic solar cell.

In another aspect of the present invention, provided herein is a method for manufacturing a flexible device, including forming a first electrode layer on a central area of a substrate, excluding edge areas of both ends of the substrate in a widthwise direction, forming an active layer on the first electrode layer by performing all-over coating on the first electrode layer, while transferring the substrate provided with the first electrode layer formed thereon, forming a second electrode layer on the all-over coated active layer, and forming a plurality of unit cells by removing partial areas of the all-over coated active layer, in order to divide the all-over coated active layer into the unit cells and to electrically insulate the unit cells.

The removal of the partial areas of the all-over coated active layer may be executed in a direction perpendicular to a lengthwise direction of the substrate at regular intervals in the lengthwise direction of the substrate.

The removal of the partial areas of the all-over coated active layer may be executed by perforating the all-over coated active layer and the substrate.

The removal of the partial areas of the all-over coated active layer may be executed at least in the central area of the substrate.

The removal of the partial areas of the all-over coated active layer may be extended to a part of each of the edge areas of the substrate.

The method may further include sealing the flexible device by forming a first barrier film under the substrate and forming a second barrier film on the unit cells.

The first electrode layer and the second electrode layer may include electrode terminals protruding in the widthwise direction of the substrate.

The method may further include forming electrode connection lines connecting the electrode terminals, in the edge area of the substrate.

The removal of the partial area of the all-over coated active layer may be executed within a region formed by a space between the neighboring unit cells, and the electrode connection line so as not to cut the electrode connection line.

The removal of the partial areas of the all-over coated active layer may be executed using a laser or a punching machine.

### [Advantageous Effects]

A method for manufacturing a flexible device in accordance with the present invention, in which patterns are divided through a physical cutting or post-treatment process after all-over coating rather than pattern printing, does not require application of various thin film process conditions according to pattern shapes and may reduce thickness variation between unit cells through all-over coating and employ a single all-over coating condition, thereby facilitating standard process establishment and raising process reliability and yield, forming cells having various sizes and manufacturing modules having various electrical specifications through the easier physical cutting or post-treatment process than pattern printing.

### [Description of Drawings]

FIG. 1 is a conceptual view illustrating a patterned stacked cross-section of a conventional organic solar cell.
FIG. 2 is a plan view schematically illustrating a flexible device in accordance with one embodiment of the present invention.
FIG. 3 is an exploded perspective view of unit cells shown in FIG. 2.
FIG. 4 is a cross-sectional view of the flexible device shown in FIG. 2, taken along line A-A'.
FIG. 5 is a perspective view illustrating some processes of a method for manufacturing a flexible device in accordance with another embodiment of the present invention, and FIG. 6 is a perspective view illustrating some processes of a conventional method for manufacturing a flexible device.
FIGS. 7 to 10 are reference views exemplarily illustrating feasibility of forming cells having various sizes and manufacturing modules having various electrical specifications by the method in accordance with another embodiment of the present invention.

### [Best Mode]

A flexible device in accordance with one embodiment of the present invention includes a substrate and a plurality of unit cells located on the substrate, the substrate includes a central area provided with the unit cells located thereon, edge areas formed at both ends of the substrate in a widthwise direction and provided with no unit cells, and perforated parts formed between the unit cells in the central area of the substrate to electrically insulate and divide the unit cells.

### [Mode for Invention]

Reference will now be made in detail to the preferred embodiments of the present invention, examples of which are illustrated in the accompanying drawings. In the drawings, the same or similar elements are denoted by the same reference numerals even though they are depicted in different drawings. In the following description of the present invention, a detailed description of known functions and configurations incorporated herein will be omitted when it may make the subject matter of the present invention rather unclear. For the same reason, some elements in the accompanying drawings may be exaggerated, omitted or schematically illustrated. Also, sizes or shapes of respective elements in the accompanying drawings may be enlarged or reduced for better understanding and convenience in description of the present invention.

A flexible device in accordance with one embodiment of the present invention includes a substrate and a plurality of unit cells located on the substrate, and the substrate includes a central area provided with the unit cells located thereon, edge areas formed at both ends of the substrate in a widthwise direction and provided with no unit cells, and perforated parts formed between the unit cells in the central area of the substrate so as to electrically insulate and divide the unit cells.

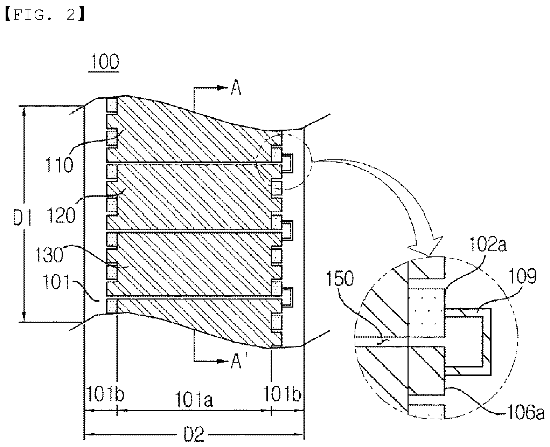

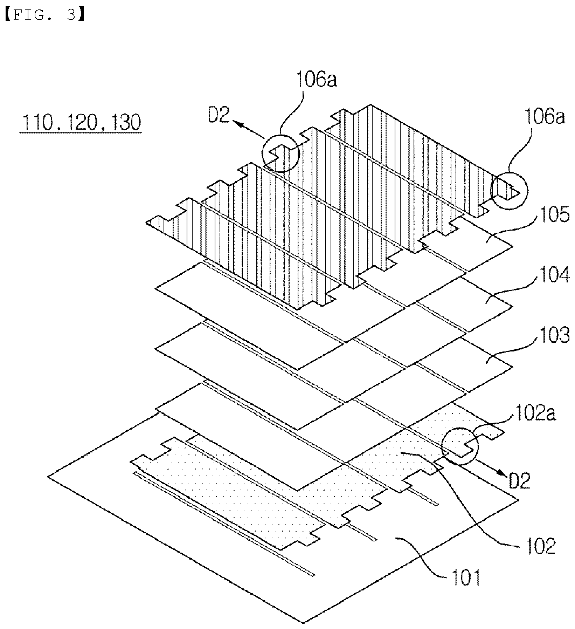

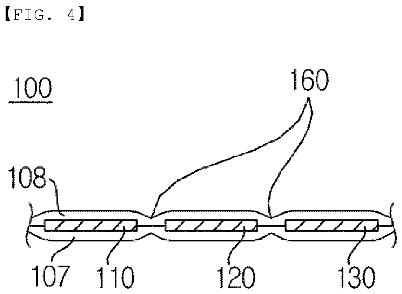

FIG. 2 is a plan view schematically illustrating a flexible device in accordance with one embodiment of the present invention, FIG. 3 is an exploded perspective view of unit cells shown in FIG. 2, and FIG. 4 is a cross-sectional view of the flexible device shown in FIG. 2, taken along line A-A' .

Although FIGS. 2 to 4 concretely illustrate an organic solar cell as one example of a flexible device, the flexible device is not limited to the organic solar cell.

With reference to FIGS. 2 to 4, a flexible device 100 includes a substrate 101, and a plurality of unit cells 110, 120, 130 located on the substrate 101.

The substrate 101 includes a central area 101a in which the unit cells 110, 120 and 130 are located, and edge areas 101b of both ends of the substrate 101 in a widthwise direction D2 in which the unit cells 110, 120 and 130 are not located. Here, the substrate 101 includes perforated parts 150 formed between the unit cells 110, 120 and 130 in the central area 101a of the substrate 101 to electrically insulate and divide the unit cells 110, 120 and 130.

The perforated parts 150 are formed through the unit cells 110, 120, 130 and the substrate 101. As the perforated parts 150 are formed through the unit cells 110, 120, 130 and the substrate 101, formation of the perforated parts 150 is facilitated. That is, in processes, removal of the substrate 101 together with removal of the unit cells 110, 120, 130 is easier than removal of only the unit cells 110, 120, 130.

Further, the perforated parts 150 may have an elongated shape in the widthwise direction D2 of the substrate 101. That is, the width of the perforated parts 150 may be at least equal to or greater than the width of the central area 101a of the substrate 101, and the length of the perforated parts 150 is desirably shorter, because, as the length of the perforated parts 150 is increased, an amount of materials to be removed is increased and a size of an active area is reduced. However, the length of the perforated parts 150 is long enough to electrically insulate the unit cells 110, 120, 130. Further, the perforated parts 150 are not limited to the elongated shape in the widthwise direction D2 of the substrate and may have any shape which may electrically insulate and divide the unit cells 110, 120, 130.

As the unit cells 110, 120, 130 are electrically insulated and divided by the perforated parts 150, the unit cells 110, 120, 130 are arranged at regular intervals in a lengthwise direction D1 of the substrate 101 (i.e., at intervals of the length of the perforated parts 150).

Each of the unit cells 110, 120, 130 includes a first electrode layer 102 and a second electrode layer 106, which are arranged on the substrate 101 so as to face each other, and an active layer 104 located between the first electrode layer 102 and the second electrode layer 106.

The substrate 101 may employ any material which is flexible, has a deformable shape and is thus generally applicable to the flexible device 100, without limitation. In more detail, the substrate 101 may include a metal foil, such as aluminum, an inorganic thin film including quartz or glass, a polymer film, such as polyethylene terephthalate (PET), polyethylene naphthalate (PEN), polycarbonate (PC), polystyrene (PS), polypropylene (PP), polyimide (PI), polyethylene sulfonate (PES), polyoxy methylene (POM), polyether ether ketone (PEEK), polyether sulfone (PES) or polyether imide (PEI), acrylonitrile styrene (AS) copolymer, acrylonitrile butadiene styrene (ABS) copolymer, triacetyl cellulose (TAC) or polyarylate (PAR), a fiber base material, a fiberglass-polymer composite, etc., and, more preferably, the substrate 101 may include a polymer film, which has high flexibility, chemical stability, mechanical strength and transparency and is easily deformable to various shapes, or a PET film.

Further, if the flexible device 100 needs to transmit light through the substrate 101, the substrate 101 may require transparency. Here, the substrate 101 may have transmittance of at least 70% or more, preferably 80% or more, in a visible light wavelength range of about 380 to 780 nm.

The first electrode layer 102 may serve as a path along which light passed through the substrate 101 reaches a photoactive layer, and include a conductive material having high transparency, a high work function of about 4.5 eV or more and low resistance. In more detail, the conductive material may be a transparent oxide, such as tin-doped indium oxide (ITO), fluorine-doped tin oxide (FTO), gallium doped ZnO (GZO: ZnOGa₂O₃), aluminum doped ZnO (AZO: ZnO-Al₂O₃), indium doped ZnO (IZO: In₂O₃-ZnO) or SnO₂-Sb₂O₃, or a multilayer structure in which the transparent oxides are stacked in the form of oxide-metal-oxide, a conductive polymer, such as PEDOT:PSS polypyrrole or polyaniline, or an organic/inorganic hybrid acquired by doping the same with a metal; a metal, such as gold, platinum, silver, chrome or cobalt, an alloy of the metal, a nanowire formed of the metal, a metal mesh or an embedded metal mesh formed of the metal or a grid of the metal, or an organic transparent electrode, such as a graphene thin film, a grapheme oxide thin film or a carbon nanotube thin film, or an organic-inorganic hybrid transparent electrode, such as a carbon nanotube thin film combined with a metal.

The second electrode layer 106 may include a material having a low work function and, in more detail, the material may be a metal, such as magnesium, calcium, sodium, potassium, titanium, indium, yttrium, lithium, gadolinium, aluminum, silver, tin, lead, stainless steel, copper or tungsten, or an alloy thereof, a material having a multilayer structure, such as LiF/Al, LiO₂/Al, LiF/Fe, Al:Li, Al:BaF₂ or Al:BaF₂:Ba, or silicon.

The active layer 104 may be a photoactive layer having a bi-layer p-n junction structure in which a hole acceptor (a p-type semiconductor) and an electron acceptor (an n-type semiconductor) are formed as separate layers, or a bulk heterojunction structure in which a hole acceptor and an electron acceptor are combined.

The hole acceptor is an organic semiconductor, such as an electro-conductive polymer or a low molecular weight organic semiconductor material, the electro-conductive polymer may be one selected from the group consisting of polythiophene, polyphenylene vinylene, polyfluorene, polypyrrole, copolymers thereof and combinations thereof, and the low molecular weight organic semiconductor material may be one selected from the group consisting of pentacene, anthracene, tetracene, perylene, oligothiophene, derivatives thereof and combinations thereof. In more detail, the hole acceptor may be one selected from the group consisting of poly-3-hexylthiophene (P3HT), poly-3-octylthiophene (P3OT), poly-p-phenylene vinylene (PPV), poly(9,9'-dioctylfluorene), poly(2-methoxy,5-(2-ethyl-hexyloxy)-1,4-phenylene vinylene (MEH-PPV), poly(2-methyl,5-(3',7'-dimethyloctyloxy))-1,4-phenylene vinylene (MDMOPPV) and combinations thereof.

The electron acceptor may be an organic, inorganic or organic-inorganic compound having high electron affinity. In more detail, the electron acceptor may be fullerene (C₆₀) or a fullerene derivative, a phthalocyanine derivative, a boron-containing polymer, one group II-VI compound semiconductor crystal selected from the group consisting of CdS, CdSe, CdTe, ZnSe and combinations thereof, an oxide semiconductor crystal, such as ZnO, SiO₂, TiO₂ or Al₂O₃, or a compound semiconductor crystal, such as CuInSe2 or CuInS. Particularly, the electron acceptor may be one selected from the group consisting of (6,6)-phenyl-C₆₁-butyric acid methyl ester (PCBM), (6,6) -phenyl-C₇₁-butyric acid methyl ester (C₇₀-PCBM), (6,6)-thienyl-C₆₁-butyric acid methyl ester (ThCBM), carbon nanotube and combinations thereof.

Further, each of the unit cells 110, 120, 130 may further selectively include a hole transport layer 103 or an electron transport layer 105 between the first electrode layer 102 or the second electrode layer 106 and the active layer 104.

The hole transport layer 103 is a layer assisting holes generated by the active layer 104 to move to an electrode and may include one hole transport material selected from the group consisting of poly(3,4-ethylenedioxythiophene) (PEDOT), poly(styrene sulfonate) (PSS), polyaniline, phthalocyanine, pentacene, poly(diphenyl acetylene), poly(t-butyl)diphenylacetylene, poly(trifluoromethyl)diphenylacetylene, copper phthalocyanine (Cu-PC), poly(bis-trifluoromethyl)acetylene, poly(bis-t-butyldiphenyl)acetylene, poly(trimethylsilyl)diphenylacetylene, poly(carbazole) diphenylacetylene, polydiacetylene, polyphenylacetylene, poly(pyridine acetylene), poly(metoxyphenylacetylene), poly(methylphenylacetylene), poly(t-butyl)phenylacetylene, poly(nitrophenylacetylene), poly(trifluoromethyl)phenylacetylene, poly(trimethylsilyl)phenylacetylene, derivatives thereof, molybdenum oxide (MoOₓ), vanadium oxide (V₂O₅), nickel oxide (NiO), tungsten oxide (WOₓ) and combinations thereof. As one example, the hole transport layer 103 may include a mixture of PEDOT and PSS. Further, as the hole transport layer, a self-assembled thin film formed by depositing a material, such as Ni, and then executing heat treatment may be used.

The electron transport layer 105 may include an electron-extracting metal oxide and, in more detail, the electron-extracting metal oxide may be a metal complex of 8-hydroxyquinoline, a complex including aluminum tris(8-hydroxyquinoline) (Alq3), a metal complex including 8-hydroxy-quinolinato lithium (Liq), lithium fluoride (LiF), Ca, titanium oxide (TiOₓ), zinc oxide (ZnO), cesium carbonate (Cs₂CO₃), a non-conjugated polymer, a non-conjugated polyelectrolyte, a conjugated polyelectrolyte or an n-type metal oxide without being limited thereto. For example, the n-type metal oxide may be TiOₓ, TiOₓ doped with Ni or Al, ZnO or Cs₂CO₃. Further, as the electron transport layer, a self-assembled thin film of a metal layer may be used, or a polymer-based or organic/inorganic hybrid material may be used because of stability problems, such as change of an oxidation state due to reversible energy.

The unit cells 110, 120 and 130 may be formed to have a structure in which the first electrode layer (positive electrode) 102, the hole transport layer 103, the active layer 104, the electron transport layer 105 and the second electrode layer (negative electrode) 106 are sequentially stacked on the substrate 101, or be formed to have an inverted structure in which the first electrode layer (negative electrode) 102, the electron transport layer 105, the active layer 104, the hole transport layer 103 and the second electrode layer (positive electrode) 106 are sequentially stacked on the substrate 101.

The first electrode layer 102 and the second electrode layer 106 include electrode terminals 102a and 106a protruding in the widthwise direction D2 of the substrate 101. That is, the electrode terminals 102a and 106a of the first electrode layer 102 and the second electrode layer 106 are formed in the central area 101a of the substrate 101 so as to protrude toward the edge areas 101b of the substrate 101. Here, although the second electrode layer 106 is formed above the active layer 104, the electrode terminals 106a of the second electrode layer 106 may be formed so as to surround the side surface of the active layer 104 and contact the surface of the substrate 101.

The electrode terminals 102a of the first electrode layer 102 and the electrode terminals 106a of the second electrode layer 106 may be alternately arranged in the lengthwise direction D1 of the substrate 101. However, the present invention is not limited thereto, and the electrode terminals 102a of the first electrode layer 102 may protrude toward one edge area 101b of the substrate 101 in the widthwise direction D2 and the electrode terminals 106a of the second electrode layer 106 may protrude toward the other edge 101b of the substrate 101 in the widthwise direction D2.

Further, although FIGS. 2 and 3 illustrate each of the unit cells 110, 120 and 130 as including four electrode terminals 102a of the first electrode layer 102 and four electrode terminals 106a of the second electrode layer 106, each of the unit cells 110, 120 and 130 may include only one electrode terminal 102a of the first electrode layer 102 and only one electrode terminal 106a of the second electrode layer 106, without being limited thereto.

The flexible device 100 may include electrode connection lines 109, which connect the electrode terminals 102a and 106a, in the edge areas 101b of the substrate 101. The electrode connection lines 109 include a material having a low work function like the second electrode layer 106 and, in more detail, such a material may be magnesium, calcium, sodium, potassium, titanium, indium, yttrium, lithium, aluminum, silver, tin, lead, stainless steel, copper, tungsten or silicon.

Here, the perforated part 150 may be formed only within a region formed by a space between the unit cells, for examples, the unit cell 120 and the unit cell 130, and the electrode connection line 109 so as not to cut the electrode connection line 109.

Further, the perforated parts 150 may not be formed only in the central area 101a of the substrate 101 but may be extended to a part of each of the edge areas 101b of the substrate 101, and in this case, the perforated parts 150 may not be extended to the end of the substrate 101 in the widthwise direction D2 so as to prevent cutting of the substrate 101 or cutting of the electrode connection lines 109.

The flexible device 100 may further include a first barrier film 107 formed under the substrate 101 and a second barrier film 108 formed on the unit cells 110, 120 and 130.

The first barrier film 107 and the second barrier film 108 serve to prevent contact between the unit cells 110, 120 and 130 and oxygen or moisture so as to prevent performance degradation of the unit cells 110, 120 and 130 due to contact with oxygen or moisture.

As the first barrier film 107 or the second barrier film 108, any material, which is generally used as a film so as to prevent contact between the unit cells 110, 120 and 130 of the flexible device 100 and oxygen or moisture, may be used without limitation. In more detail, a metal oxide or a metal nitride, such as silicon oxide, silicon nitrile or aluminum oxide, acrylic resin, epoxy resin, silicone resin, fluorine resin, styrene resin, polyolefin resin, thermoplastic elastomer, polyoxyalkylene resin, polyester resin, polyvinyl chloride resin, polycarbonate resin, polyphenylsulfide resin, polyamide resin or combinations thereof will be exemplarily used as the first barrier film 107 or the second barrier film 108.

The first barrier film 107 or the second barrier film 108 may be formed by known film formation methods according to used materials and, in more detail, if a polymer, such as polyethylene terephthalate, is used, the first barrier film 107 or the second barrier film 108 may be formed by a roll-to-roll process.

The first barrier film 107 and the second barrier film 108 may have a broader width than those of the substrate 101 and the unit cells 110, 120 and 130 so as to completely seal the unit cells 110, 120 and 130, and the first barrier film 107 and the second barrier film 108 may be adhered to each other so as to be in contact with each other and thus seal the unit cells 110, 120 and 130.

Since the substrate 101 includes the perforated parts 150, the first barrier film 107 and the second barrier film 108 may be in contact with each other at the perforated parts 150. Therefore, joints 160 may be formed on the surfaces of the first barrier film 107 and the second barrier film 108. The joints 160 may improve flexibility of the flexible device 100.

Further, for the purpose of adherence between the first barrier film 107 and the second barrier film 108, the substrate 101 may further include a first adhesive layer (not shown) provided between the first barrier film 107 and the substrate 101, or further include a second adhesive layer (not shown) provided between the second barrier film 108 and the unit cells 110, 120 and 130. In this case, the first barrier film 107 and the second barrier film 108 may be in contact with each other at the perforated parts 150 by the first adhesive layer or the second adhesive layer.

The first adhesive layer and the second adhesive layer are not limited to a specific material in the present invention and may employ any material which may fix the first barrier film 107 or the second barrier film 108. For example, the material of the first adhesive layer and the second adhesive layer may be a gluing agent or an adhesive formed of epoxy resin, polyester resin, acrylic resin, phenolic resin, vinyl resin, polyimide, polybenzimidazole, silicone-based resin, urethane-based resin, melamine urea resin, etc., and preferably the first adhesive layer and the second adhesive layer may be adhesive layers formed of ethylene vinyl acetate (EVA), an optically clear adhesive (OCA) or an optically clear resin (OCR).

A method for manufacturing a flexible device 100 in accordance with another embodiment of the present invention includes forming a first electrode layer 102 on a central area 101a of a substrate 101, excluding edge areas 101b of both ends of the substrate 101 in a widthwise direction D2, forming an active layer 104 on the first electrode layer 102 by performing all-over coating on the first electrode layer 102, while transferring the substrate 101 provided with the first electrode layer 102 formed thereon, forming a second electrode layer 106 on the all-over coated active layer 104, and forming a plurality of unit cells 110, 120 and 130 by removing partial areas of the all-over coated active layer 104, in order to divide the all-over coated active layer 104 into the unit cells 110, 120 and 130 and to electrically insulate the unit cells 110, 120 and 130.

Here, respective operations of the method for manufacturing the flexible device 100 will be described in detail.

First, the first electrode layer 102 is formed on the central area 101a of the substrate 101, excluding the edge areas 101b of both ends of the substrate 101 in the widthwise direction D2. The first electrode layer 102 may be formed by performing screen printing, gravure printing, gravure-offset printing, thermal vapor deposition, e-beam deposition, RF or magnetron sputtering, chemical deposition or other similar methods using a material forming the first electrode layer 102 on the substrate 101.

The first electrode layer 102 may include electrodes 102a protruding in the widthwise direction D2 of the substrate 101. Here, the first electrode layer 102 may be formed so as to include the electrode terminals 102a by patterning.

Thereafter, thin film layers, such as the active layer 104 and selectively a hole transport layer 103 or an electron transport layer 105, may be formed on the first electrode layer 102 by performing all-over coating on the first electrode layer 102 while transferring the substrate 101 provided with the first electrode layer 102 formed thereon.

A coating solution to form the active layer 104 includes a coating material and a solvent. The coating material may be an organic or inorganic material forming the active layer 104, the hole transport layer 103 or the electron transport layer 105. In more detail, the coating material is a mixture of a hole acceptor and an electron acceptor in case of the active layer 104, a hole transport material in case of the hole transport layer 103, and an electron transport material in case of the electron transport layer 105.

The content of the above-described coating material may be properly determined according to the purpose of a thin film layer desired to be formed and, in more detail, the content of the coating material may be 5 to 99% by weight with respect to the total weight of the coating solution.

As the solvent, any solvent which may dissolve or disperse the coating material, may be used without limitation. In more detail, the solvent may be water, alcohol, such as ethanol, methanol, propanol, isopropyl alcohol, butanol, etc., an organic solvent, such as acetone, pentane, toluene, benzene, diethyl ether, methyl butyl ether, N-methyl pyrrolidone (NMP), tetrahydrofuran (THF), dimethylformamide (DMF), dimethylacetamide (DMAC), dimethyl sulfoxide (DMSO), carbon tetrachloride, dichloromethane, dichloroethane, trichloroethylene, chloroform, chlorobenzene, dichlorobenzene, trichlorobenzene, cyclohexane, cyclopentanone, cyclohexanone, dioxane, terpineol, methyl ethyl ketone, or a mixture thereof, and, when the coating solution is manufactured, the above-described solvent materials may be properly selected according to kinds of coating materials.

The content of the solvent may be an amount of the remainder of the coating solution and, preferably, be 1 to 95% by weight with respect to the total weight of the coating solution. If the content of the solvent exceeds 95% by weight, it is difficult to acquire a desired function of the thin film layer and, if the content of the solvent is less than 1% by weight, it is difficult to form the thin film having a uniform thickness.

The coating solution having the above-described composition may be manufactured by dispersing or dissolving the above-described coating material in the solvent.

When the thin film layers are formed on the substrate 101, the substrate 101 may be transferred in a roll-to-roll manner, and the transfer speed of the substrate 101 may be 0.01 m/min to 20 m/min, preferably 0.1 m/min to 5 m/min. The transfer speed may be optimized according to coating and drying speeds of the thin film layers using roll-to-roll equipment.

Coating of the transferred substrate 101 with the coating solution may be carried out through a method, such as slot-die coating, spraying, spin-coating, dipping, printing or doctor-blading and is preferably carried out through slot-die coating. Here, the thin film layers are not coated on the substrate 101 so as to have a patterned shape such that unit cells 110, 120 and 130 are directly formed on the substrate 101, but are coated on the entire surface of the substrate 101, i.e., all-over coating. Here, all-over coating may be carried out only in the central area 101a of the substrate 101 provided with the first electrode layer 102 formed thereon, and is preferably carried out so as not to cover the protruding electrode terminals 102a of the first electrode layer 102.

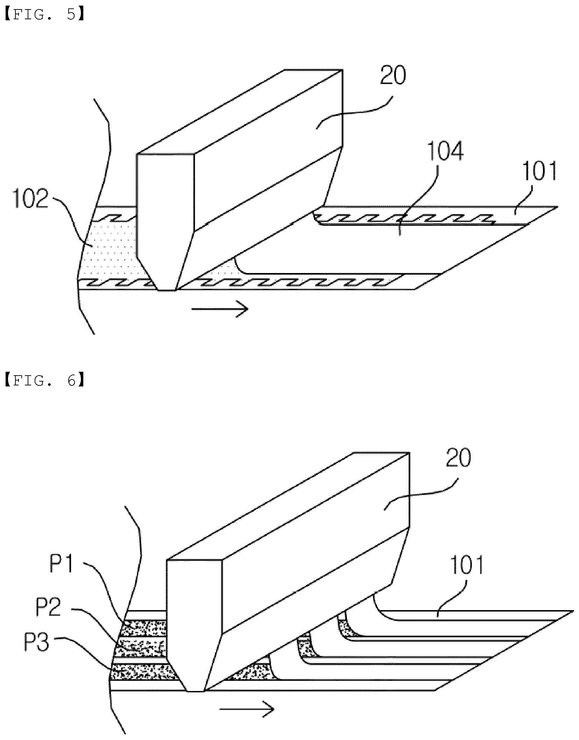

FIG. 5 is a perspective view illustrating a process of all-over coating the substrate 101 provided with the first electrode layer 102, patterned to have the protruding electrode terminals 102a, with the active layer 104 using a slot die 20, and FIG. 6 is a perspective view illustrating a process of coating electrode layers, formed as stripe patterns P1, P2 and P3, directly with thin film layers formed as stripe patterns using the slot die according to the conventional method. With reference to FIGS. 5 and 6, in the method for manufacturing the flexible device 100 in accordance with the present invention, the thin film layers are formed by all-over coating and, thus, various thin film process conditions according to pattern shapes are not applied but a single all-over coating condition is applied, thereby facilitating standard process establishment and raising process reliability and yield.

After coating of the coating solution, a post-treatment process in which drying and heat treatment of the coated base material are selectively executed may be carried out. Here, as a drying method, hot air drying, NIR drying or UV drying may be carried out at a temperature of 50 to 400°C, preferably 70 to 200°C, for 1 to 30 minutes.

For example, in case of the active layer 104, after the coating process, the post-treatment process in which drying and heat treatment are executed at a temperature of 25 to 150°C for 5 to 145 minutes may be carried out. Proper adjustment of the drying process and the heat treatment process may induce proper phase separation between the electron acceptor and the hole acceptor and induce orientation of the electron acceptor. In the heat treatment process, if a heat treatment temperature is lower than 25°C, mobility of the electron acceptor and the hole acceptor is lowered and thus heat treatment effects may be insignificant and, if the heat treatment temperature is higher than 150°C, performance of the active layer 104 may be lowered due to degradation of the electron acceptor. Further, if a heat treatment time is less than 5 minutes, mobility of the electron acceptor and the hole acceptor is lowered and thus heat treatment effects may be insignificant and, if the heat treatment time exceeds 145 minutes, performance of the active layer 104 may be lowered due to degradation of the electron acceptor.

The thicknesses of the thin film layers formed by the above-described method may be properly determined according to purposes thereof, and are preferably 10 nm to 10 µm, more preferably 20 nm to 1 µm. If the thicknesses of the thin film layers are within the above-described range, a manufactured device may have the highest efficiency.

Thereafter, the second electrode layer 106 is formed on the all-over coated active layer 104. The second electrode layer 106 may be formed by performing screen printing, gravure printing, gravure-offset printing, thermal vapor deposition, e-beam deposition, RF or magnetron sputtering, chemical deposition or other similar methods using a material forming the second electrode layer 106 on the thin film layers.

The second electrode layer 106 may include electrodes 106a protruding in the widthwise direction D2 of the substrate 101. Here, the second electrode layer 106 may be formed so as to include the electrode terminals 106a by patterning.

Further, the method for manufacturing the flexible device 100 may further include forming electrode connection lines 109, which connect the electrode terminals 102a and 106a, in the edge areas 101b of the substrate 101 simultaneously with formation of the second electrode layer 106 or after formation of the second electrode layer 106. The electrode connection lines 109 may be formed of a metal material having a low work function similar to the second electrode layer 106, and be formed through a similar method to the second electrode layer 106, i.e., screen printing, gravure printing, gravure-offset printing, thermal vapor deposition, e-beam deposition, RF or magnetron sputtering, chemical deposition or other similar methods.

Finally, in order to divide the all-over coated thin film layers selectively including the first electrode layer 102 and the second electrode layer 106 into a plurality of unit cells 110, 120 and 130 while electrically insulating the unit cells 110, 120 and 130, the unit cells 110, 120 and 130 are formed by removing partial areas of the all-over coated thin film layers selectively including the first electrode layer 102 and the second electrode layer 106.

Here, together with the all-over coated thin film layers, partial areas of the substrate 101 may be selectively removed and, in this case, the all-over coated active layer and the substrate may be perforated. In this case, removal of partial areas of the all-over coated thin film layers is facilitated. That is, rather than removal of only the all-over coated thin film layers, both the all-over coated thin film layers and the substrate 101 may be perforated.

Although removal of the partial areas of the all-over coated active layer may be executed using a laser or a punching machine, the present invention is not limited thereto, and any method, through which the thin film layers selectively including the first electrode layer 102 and the second electrode layer 106 and the substrate 101 may be removed, may be used.

Removal of the partial areas of the all-over coated active layer may be executed in a direction perpendicular to the lengthwise direction D1 (i.e., the widthwise direction D2 of the substrate 101) at regular intervals in the lengthwise direction D1 of the substrate 101 (i.e., at intervals of the length of the unit cells 110, 120 and 130). Thereby, the unit cells 110, 120 and 130 are arranged at regular intervals in the lengthwise direction D1 of the substrate 101 (for example, at intervals of the length of the perforated parts 150) .

Here, removal of the partial area of the all-over coated active layer may be executed within a region formed by a space between the unit cells, for example, the unit cell 120 and the unit cell 130, and the electrode connection line 109 so as not to cut the electrode connection line 109.

Further, removal of the partial areas of the all-over coated active layer may be executed only in the central area 101a of the substrate 101 but may be extended to a part of each of the edge areas 101b of the substrate 101, and in this case, removal of the partial areas of the all-over coated active layer may not be extended to the end of the substrate 101 in the widthwise direction D2 so as to prevent cutting of the substrate 101 into two pieces or cutting of the electrode connection lines 109.

The method for manufacturing the flexible device 100 may further include sealing the flexible device 100 by forming a first barrier film 107 under the substrate 101 and forming a second barrier film 108 on the unit cells 110, 120 and 130.

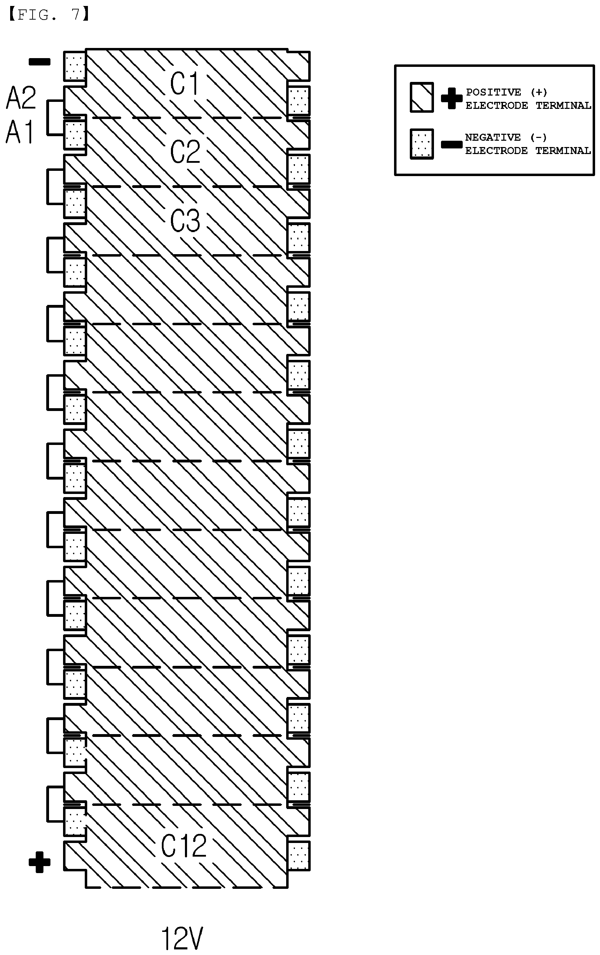

FIGS. 7 to 10 are reference views exemplarily illustrating feasibility of forming cells having various sizes and manufacturing modules having various electrical specifications through perforation.

First, FIG. 7 illustrates one example in which a front cell formed by all-over coating is divided into twelve unit cells C1 to C12. In this case, a positive (+) electrode terminal of the unit cell C1 is connected to a negative (-) electrode terminal of the unit cell C2 in series, and the remaining cells are connected in series in the same manner. When the twelve unit cells C1 to C12 are connected in series, output voltage of one module corresponds to "voltage of the unit cell (any one of the unit cells C1 to C12) × 12".

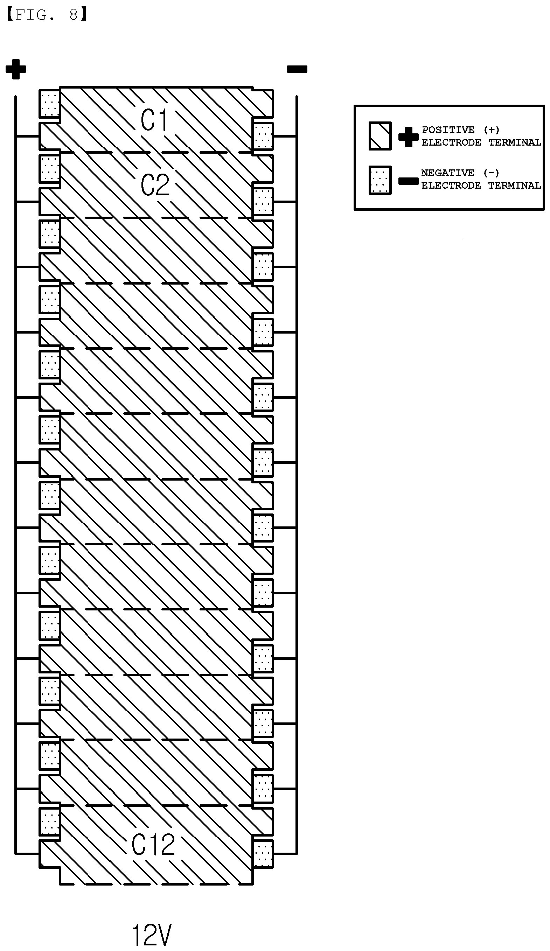

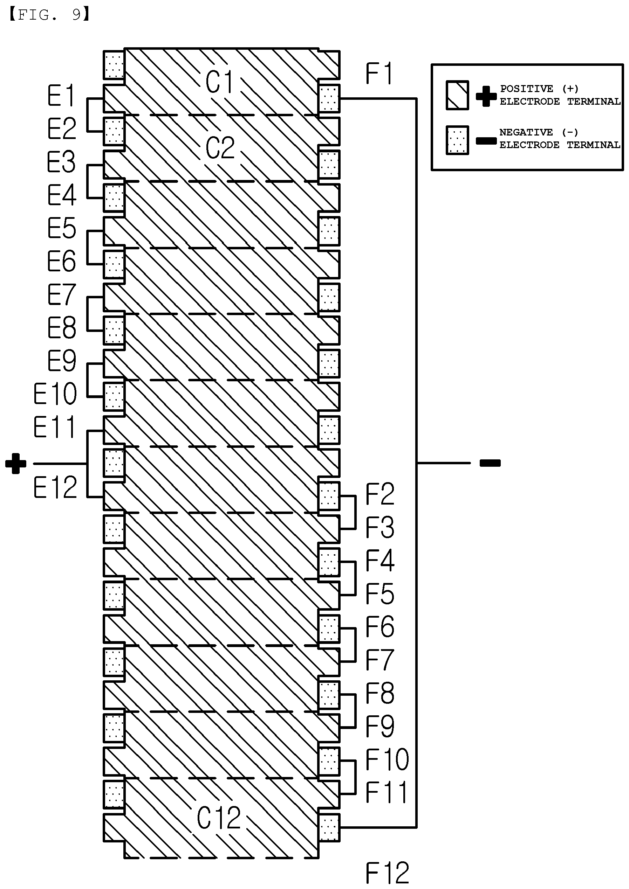

Next, FIG. 8 illustrates another example in which a front cell formed by all-over coating is divided into twelve unit cells C1 to C12. FIG. 9 exemplarily illustrates the case that positive (+) electrode terminals and negative (-) electrode terminals of the twelve unit cells C1 to C12 are connected in parallel so as to increase a quantity of current of the unit cells C1 to C12. In such parallel connection, output current of all the unit cells C1 to C12 connected in parallel corresponds to 12 times current capacity of each unit cell (any one of the unit cells C1 to C12).

Next, FIG. 9 illustrates one example in which a front cell formed by all-over coating is divided into twelve unit cells C1 to C12, six unit cells are connected in series so as to form a pair of serial lines, and the serial lines are connected in parallel so that output current is set to be two times output current of one serial line formed by the twelve unit cells C1 to 12. With reference to FIG. 9, the unit cell C1 to the unit cell C6 are connected in series so as to form a first serial line, the unit cell C7 to the unit cell C12 are connected in series so as to form a second serial line, and the first serial line and the second serial line are connected in parallel. For this purpose, neighboring electrode terminals out of electrode terminals E1 to E11 are connected in series to form the first serial line, neighboring electrode terminals out of electrode terminals F2 to F11 are connected in series to form the second serial line, and an electrode terminal F1 and an electrode terminal F12 are connected in common and an electrode terminal E11 and an electrode terminal E12 are connected in common so that the first serial line and the second serial line are connected in parallel.

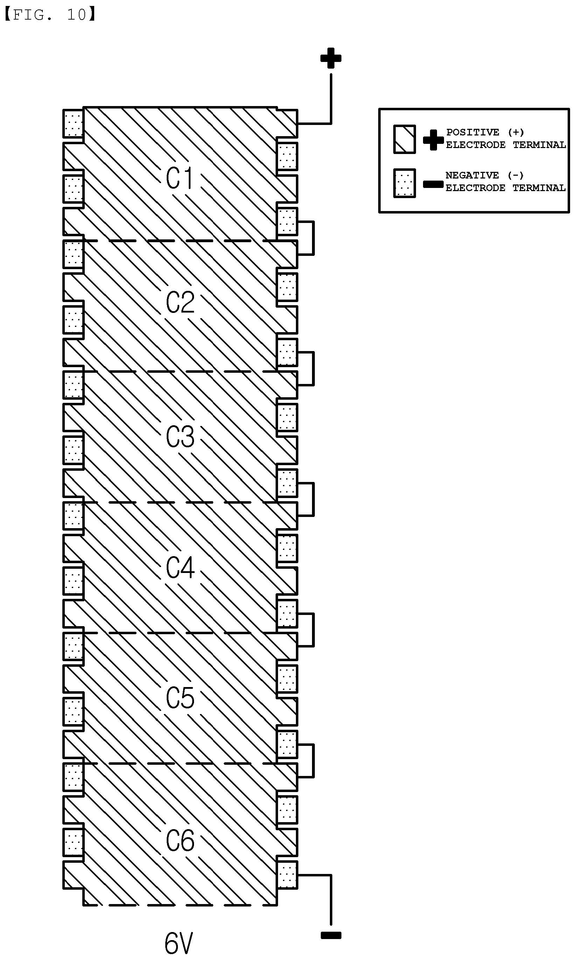

Finally, FIG. 10 illustrates one example in which a front cell formed by all-over coating is divided into six unit cells C1 to C6 and the six unit cells C1 to C6 are connected in series. With reference to FIG. 10, the front cell formed by all-over coating is divided into the six unit cells C1 to C6 and the area of each of the unit cells C1 to C6 is two times the area of each of the unit cells shown in FIGS. 7 to 9. Increase in area indicates that the current capacity of the unit cells C1 to C6 corresponds to two times the current capacity of the unit cells shown in FIGS. 7 to 9. Therethrough, it may be understood that using the method for manufacturing the flexible device 100, cells having various sizes may be formed and modules having various electrical specifications may be manufactured through an easier physical cutting or post-treatment process than pattern printing.

That is, the method for manufacturing the flexible device 100, in which patterns are divided through a physical cutting or post-treatment process after all-over coating rather than pattern printing, does not require application of various thin film process conditions according to pattern shapes and may reduce thickness variation between unit cells through all-over coating and employ a single all-over coating condition, thereby facilitating standard process establishment and raising process reliability and yield, forming cells having various sizes and manufacturing modules having various electrical specifications through the easier physical cutting or post-treatment process than pattern printing.

### [Industrial Applicability]

A method for manufacturing a flexible device and a flexible device manufactured thereby in accordance with the present invention, in which patterns are divided through a physical cutting or post-treatment process after all-over coating rather than pattern printing, do not require application of various thin film process conditions according to pattern shapes and may reduce thickness variation between unit cells through all-over coating and employ a single all-over coating condition, thereby facilitating standard process establishment and raising process reliability and yield, forming cells having various sizes and manufacturing modules having various electrical specifications through the easier physical cutting or post-treatment process than pattern printing.

## Claims

1. A flexible device comprising:
a substrate; and
a plurality of unit cells located on the substrate,
wherein the substrate comprises:
a central area provided with the unit cells located thereon and edge areas formed at both ends of the substrate in a widthwise direction and provided with no unit cells; and
perforated parts formed between the unit cells in the central area of the substrate to electrically insulate and divide the unit cells.

2. The flexible device according to claim 1, wherein the unit cells are arranged at regular intervals in a lengthwise direction of the substrate.

3. The flexible device according to 1, wherein the perforated parts are extended to a part of each of the edge areas of the substrate.

4. The flexible device according to 1, wherein the perforated parts are formed through the unit cells and the substrate.

5. The flexible device according to 1, wherein the perforated parts have an elongated shape in the widthwise direction of the substrate.

6. The flexible device according to 1, further comprising:
a first barrier film formed under the substrate; and
a second barrier film formed on the unit cells.

7. The flexible device according to 6, further comprising:
a first adhesive layer provided between the first barrier film and the substrate; and
a second adhesive layer provided between the second barrier film and the unit cells.

8. The flexible device according to 6, wherein the first barrier film and the second barrier film are in contact with each other at the perforated parts.

9. The flexible device according to 8, wherein, as the first barrier film and the second barrier film are in contact with each other at the perforated parts, joints are formed on the surfaces of the first barrier film and the second barrier film.

10. The flexible device according to 1, wherein each of the unit cells comprises a first electrode layer and a second electrode layer, arranged on the substrate so as to face each other, and an active layer located between the first electrode layer and the second electrode layer.

11. The flexible device according to 10, wherein the first electrode layer and the second electrode layer comprise electrode terminals protruding in the widthwise direction of the substrate.

12. The flexible device according to 11, wherein the electrode terminals of the first electrode layer and the electrode terminals of the second electrode layer are alternately arranged in a lengthwise direction of the substrate.

13. The flexible device according to 11, further comprising electrode connection lines configured to connect the electrode terminals, in the edge areas of the substrate.

14. The flexible device according to 13, wherein the perforated part is formed within a region formed by a space between the neighboring unit cells, and the electrode connection line so as not to cut the electrode connection line.

15. The flexible device according to 1, being an organic solar cell.

16. A method for manufacturing a flexible device, comprising:
forming a first electrode layer on a central area of a substrate, excluding edge areas of both ends of the substrate in a widthwise direction;
forming an active layer on the first electrode layer by performing all-over coating on the first electrode layer, while transferring the substrate provided with the first electrode layer formed thereon;
forming a second electrode layer on the all-over coated active layer; and
forming a plurality of unit cells by removing partial areas of the all-over coated active layer, in order to divide the all-over coated active layer into the unit cells and to electrically insulate the unit cells.

17. The method according to claim 16, wherein the removal of the partial areas of the all-over coated active layer is executed in a direction perpendicular to a lengthwise direction of the substrate at regular intervals in the lengthwise direction of the substrate.

18. The method according to claim 16, wherein the removal of the partial areas of the all-over coated active layer is executed by perforating the all-over coated active layer and the substrate.

19. The method according to claim 16, wherein the wherein the removal of the partial areas of the all-over coated active layer is executed at least in the central area of the substrate.

20. The method according to claim 16, wherein the removal of the partial areas of the all-over coated active layer is extended to a part of each of the edge areas of the substrate.

21. The method according to claim 16, further comprising sealing the flexible device by forming a first barrier film under the substrate and forming a second barrier film on the unit cells.

22. The method according to claim 16, wherein the first electrode layer and the second electrode layer comprise electrode terminals protruding in the widthwise direction of the substrate.

23. The method according to claim 22, further comprising forming electrode connection lines connecting the electrode terminals, in the edge area of the substrate.

24. The method according to claim 23, wherein the removal of the partial area of the all-over coated active layer is executed within a region formed by a space between the neighboring unit cells, and the electrode connection line so as not to cut the electrode connection line.

25. The method according to claim 16, wherein the removal of the partial areas of the all-over coated active layer is executed using a laser or a punching machine.
